# EUROPEAN PATENT APPLICATION

(11) **EP 2 051 297 A2**
(43) Date of publication of application: **22.04.2009**
(21) Application number: 08166710.7
(22) Date of filing: 15.10.2008
(51) Int. Cl.: H01L 21/78, H01L 21/308

(54) **Substrate dividing method**

(30) Priority: 15.10.2007 JP 2007268123
(71) Applicant: Shinko Electric Industries Co., Ltd., Nagano-shi, Nagano 381-2287 (JP)
(72) Inventor: Taguchi, Yuichi Shinko Electric Industries Co., Ltd, Nagano 381-2287 (JP); Shiraishi, Akinori Shinko Electric Industries Co., Ltd., Nagano 381-2287 (JP); Sunohara, Masahiro Shinko Electric Industries Co., Ltd., Nagano 381-2287 (JP); Murayama, Kei Electric Industries Co., Ltd., Nagano 381-2287 (JP); Sakaguchi, Hideaki Shinko Electric Industries Co., Ltd., Nagano 381-2287 (JP); Higashi, Mitsutoshi Shinko Electric Industries Co., Ltd., Nagano 381-2287 (JP)
(74) Representative: Zimmermann & Partner

(57) **Abstract**

A method of dividing a substrate 10 into individual pieces by setting dividing lines A used to dividing the substrate 10 into individual pieces at a predetermined interval in a vertical direction and a horizontal direction and then dividing the substrate 10 along the dividing lines A, includes a step of forming chamfering patterns 14 to form through holes, which are used to chamfer corner portions of individual pieces of the substrate, in respective intersection points between the dividing lines on the substrate, a step of forming chamfering through holes by etching the substrate 10, and a step of obtaining the individual pieces of the substrate by separating the substrate in the vertical direction and the horizontal direction along the dividing lines A respectively.

## Description

The present invention relates to a substrate dividing method of dividing a substrate such as a semiconductor wafer, a silicon substrate, or the like into individual pieces.
Further, the present disclosure also relates to individual pieces of a divided substrate.

In the step of forming a semiconductor chip from a semiconductor wafer, the step of forming a substrate (silicon chip) for an interposer from a silicon substrate, and the like, the work of forming individual semiconductor chips or silicon chips by dicing the semiconductor wafer or the silicon substrate must be done.

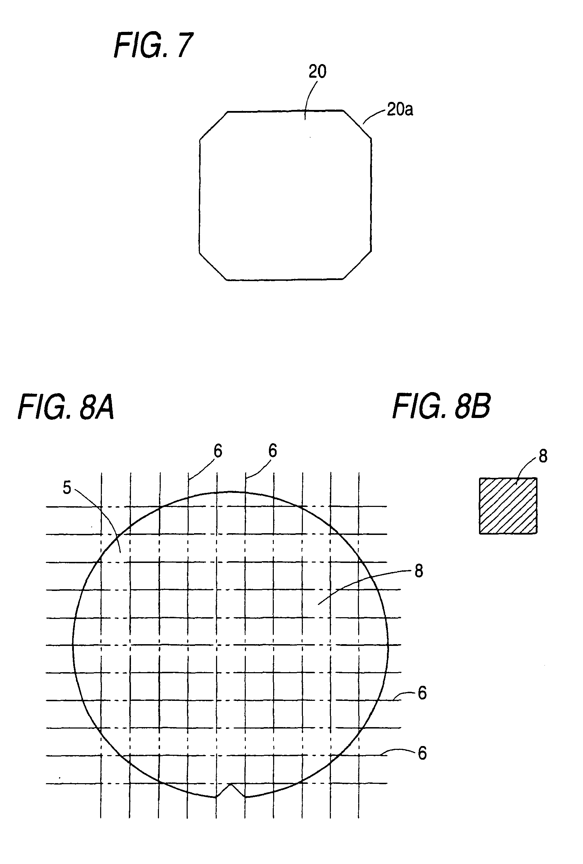

FIG.8 shows an example in which a semiconductor wafer 5 is diced to obtain the semiconductor chips as individual pieces from the semiconductor wafer 5. The semiconductor wafer 5 is separated into individual semiconductor chips 8 by pasting a dicing tape on the semiconductor wafer 5 and then moving dicing blades along the dicing lines 6 to cut the semiconductor wafer 5.

As the method of dicing the semiconductor wafer or the silicon substrate, in addition to the method of dicing using a rotary blade, there are a method of providing cutting grooves on the substrate and then dividing the substrate into individual pieces by the breaking, a method of making scratches in separated positions on the substrate and then dividing the substrate into individual pieces, a method of cutting the substrate by using the laser beam and the like. For examples, see Japanese Patent Unexamined Publications JP-A-2004-235626 and JP-A-2007-59452.

When the semiconductor chip or the silicon chip is obtained by cutting or breaking the semiconductor wafer or the silicon substrate in the lengthwise and crosswise directions, a planar shape of the chip is quadrangular and its corner portions are formed to have an acute angle respectively.
Therefore, a stress easily concentrates in the corner portions in the dicing step. As a result, such a problem comes up that the corner portions are chipped off or cracks open in the corner portions. In addition, such a problem existed that, in conveying the semiconductor chip or the silicon chip or joining the semiconductor chip or the silicon chip to the mounting substrate, the semiconductor chip or the silicon chip is damaged. In particular, if a thickness of the semiconductor chip or the silicon chip is thin, there is a problem that strength is lowered and the semiconductor chip or the silicon chip easily breaks in handling.

The problem such that the corner portions of the chip are chipped or the chipping occurs in the cutting positions when individual semiconductor chips or silicon chips are formed from the semiconductor wafer or the silicon substrate is not limited to the case where the semiconductor wafer or the silicon substrate is handled. Of course, such problem may arise similarly in the step of dicing a substrate such as a glass substrate, a ceramic substrate, or the like into substrates in unit of individual piece.

At least some of the problems in the art are overcome by the substrate dividing method of dividing a substrate into individual pieces according to claim 1 and the individual pieces of a divided substrate according to claim 10. Further aspects, details and advantages are evident from the dependent claims, the description and the accompanying drawings. The present invention has been made to solve these problems, and it is an object of the present invention to provide a substrate dividing method capable of preventing the occurrence of chips or cracks in corner portions of individual pieces of substrates upon dividing a substrate such as a semiconductor wafer, a silicon substrate, or the like, facilitating the handling of substrates by improving a strength of individual substrates, and improving manufacturing yield.

In order to attain the above object, according to a first aspect of the invention, there is provided a substrate dividing method of dividing a substrate into individual pieces, including steps of:
setting dividing lines onto the substrate in lengthwise and crosswise directions at a predetermined interval;
forming through holes on the substrate at respective intersection points of the dividing lines so as to chamfer corner portions of the individual pieces of the substrate and
dividing the substrate, on which the through holes are formed, into individual pieces along the dividing lines.

Further, the step of forming the through holes may include:
coating a surface of the substrate with a resist; and/or
forming chamfering patterns on the resist so as to expose a surface of the substrate at the respective intersection points of the dividing lines and/or
etching the substrate by using the resist on which the chamfering patterns are formed as a mask so as to form the through holes.
When the substrate is the silicon substrate, the through holes may be formed simply by etching the silicon substrate by the RIE (Reactive Ion Etching) method.
Further, each of the chamfering patterns may be formed as a pattern of which shape corresponds to a contour of the through hole with predetermined width. Accordingly, the through holes can be formed easily.

Furthermore, the substrate may be divided into individual pieces by cutting the substrate by a dicing blade along the dividing lines. The substrate may be divided into individual pieces by cleaving the substrate along the dividing lines. Accordingly, the through holes are formed easily without fail.
In addition, the dividing lines may be set so as to be in parallel with a direction of a crystal growth face of the substrate.

Each of the through holes may be shaped into a quadrangle which surrounds the intersection point of the dividing lines and four vertexes of which are preferably positioned on the dividing line, respectively. Further, each of the through holes may be shaped into a modified quadrangular shape whose respective sides are convexly curved toward the intersection point of the dividing lines, respectively. Therefore, individual pieces of the substrate in which the corner portions are chamfered linearly are obtained by dividing the substrate into individual pieces. The individual pieces of the substrate may be preferably obtained in a state that the corner portions are chamfered like an R-shape (circular arc shape).
Also, a silicon substrate such as a semiconductor wafer or the like is employed preferably as the substrate.

According to the substrate dividing method of the present invention, the chamfering through holes may be formed in the intersecting positions of the dividing lines on the substrate, and then the substrate is preferably divided into individual pieces along the dividing lines. Therefore, respective corner portions of the individual pieces of the substrate are chamfered and thus, the strength of individual pieces of the substrate can be improved and individual pieces of the substrate can be handled easily.
Further, the through holes for forming the chamfering may be formed on the substrate in advance. Therefore, in cutting or dividing the substrate, the corner portions of individual pieces of the substrate are prevented from chipping or opening cracks in the corner portions.
According to a further aspect of the present disclosure, there is provided a method of dividing a substrate into individual pieces by setting dividing lines used to dividing the substrate into individual pieces at a predetermined interval in a vertical direction and a horizontal direction and then dividing the substrate along the dividing lines, includes a step of forming chamfering patterns to form through holes, which are used to chamfer corner portions of individual pieces of the substrate, in respective intersection points between the dividing lines on the substrate, a step of forming chamfering through holes by etching the substrate, and a step of obtaining the individual pieces of the substrate by separating the substrate in the vertical direction and the horizontal direction along the dividing lines respectively.
Embodiments are also directed to apparatuses for carrying out the disclosed methods and including apparatus parts for performing each described method steps. These method steps may be performed by way of hardware components, a computer programmed by appropriate software, by any combination of the two, or in any other manner. Furthermore, embodiments are also directed to methods by which the described apparatus operates or by which the described apparatus is manufactured. It includes method steps for carrying out functions of the apparatus or manufacturing parts of the apparatus.

Embodiments of the present disclosure will be described with respect to the accompanying drawings in more detail in the following.
FIGs.1A and 1B are plan views of a state that chamfering patterns are formed on a surface of a silicon substrate.
FIGs.2A through 2C are sectional views showing steps required until through holes are formed in the silicon substrate.
FIG. 3A is a plan view of a state that the silicon substrate is diced by using a dicing blade
FIG. 3B is a plan view of a silicon chip by dicing the silicon substrate.
FIG.4 is a plan view of a silicon chip obtaining by cleaving the silicon substrate.
FIGs.5A and 5B are plan views showing another example of the chamfering pattern.
FIGs.6A and 6B are plan views showing still another example of the chamfering pattern.
FIG.7 is a plan view of the silicon chip.
FIGs.8A and 8B are explanatory views showing the conventional method of dicing a semiconductor wafer.

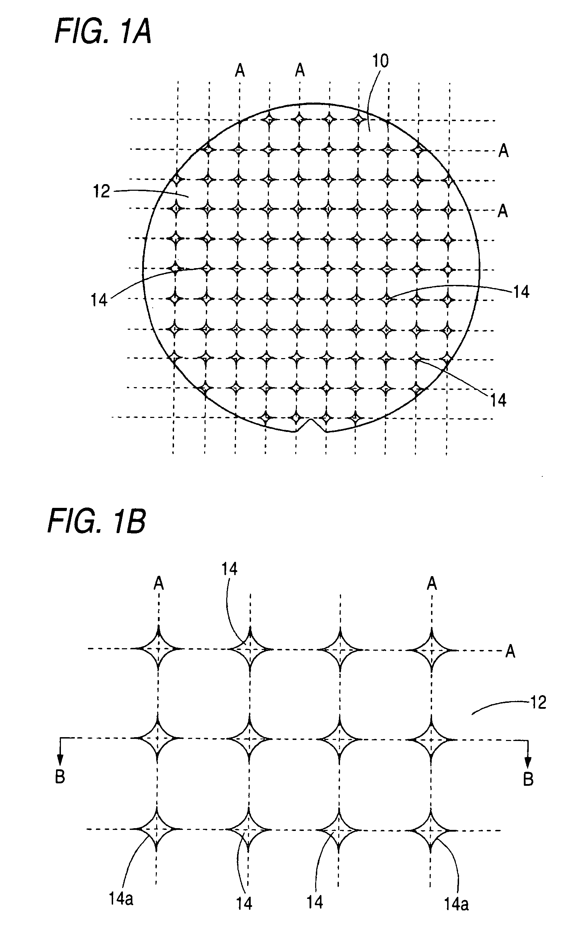

FIGs.1A and 1B show a step of forming divide silicon chips from a silicon substrate, as an example of a substrate dividing method according to the present invention.
FIGs.1A and 1B show states that chamfering patterns 14 from which a surface of a silicon substrate 10 is exposed are formed by coating a resist 12 on the surface of the silicon substrate 10 and then exposing and developing the resist 12. The chamfering patterns 14 are aligned lengthwise and crosswise at a predetermined interval and are provided at positions which correspond to intersection points where dividing lines A for dividing the silicon substrate 10 into individual pieces are intersected mutually. (The dividing lines may be virtual lines.)

The chamfering patterns 14 are shown in an enlarged manner in FIG.1B. The chamfering pattern 14 is provided so as to chamfer respective corner portions of individual divide silicon chips 20 when the silicon substrate 10 is divided into individual pieces. The chamfering pattern 14 is formed as a modified quadrangular shape whose sides are formed like a circular arc, respectively, like a rhombus that surrounds an intersection point of the dividing lines A. In this embodiment, a chamfering line 14a constituting each side of the chamfering pattern 14 is shaped into a circular arc that is convex toward the intersection point, concretely a semi-circular arc, and is set such that the dividing line A acts as a tangential line of the chamfering line 14a at an intersection position where the dividing line A intersects with the chamfering line 14a.

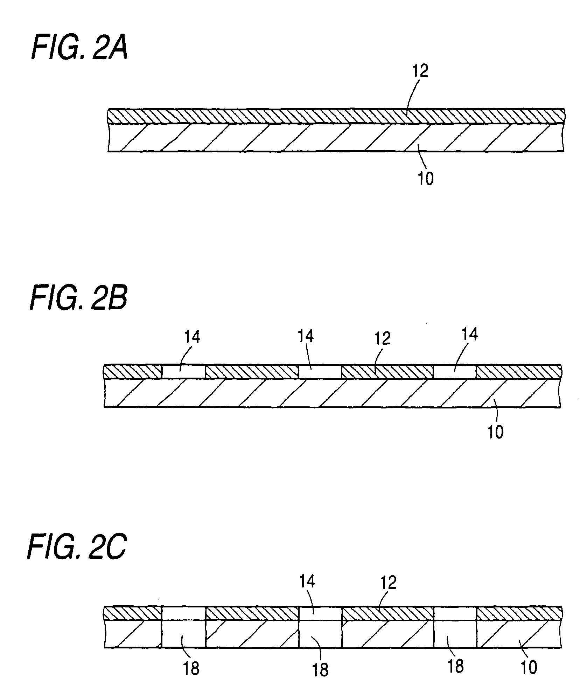

FIGs.2A through 2C show steps of forming the chamfering pattern 14 on the silicon substrate 10 by sectional views that are viewed from a B-B line in FIG.1B.
FIG.2A shows a state that a surface of the silicon substrate 10 is coated with resist 12. The resist 12 can be formed by laminating a dry film resist on the surface of the silicon substrate 10.
FIG.2B shows a state that the chamfering patterns 14 are formed by exposing and developing the resist 12 at positions which correspond to the intersection points of the dividing lines A (see FIG.1B). As described above, the surface of the silicon substrate 10 is exposed from the locations where the chamfering patterns 14 are formed.

Then, the dry etching is applied to the silicon substrate 10. The silicon substrate 10 is etched in a thickness direction by the dry etching in the locations where the surface of the silicon substrate 10 is exposed. Thus, through holes 18 are formed in the silicon substrate 10.
FIG.2C shows a state that the through holes 18 are formed in the silicon substrate 10. In FIGs.1A and 1B, the through holes 18 are formed to pass through the silicon substrate 10 in the thickness direction in interior of the chamfering pattern 14 (the inside of the modified quadrangular shape).

As the method of dry-etching the silicon substrate 10, for example, the RIE (Reactive Ion Etching) method can be employed. According to the RIE method, the areas that are covered with the resist 12 are not etched, but the locations where the chamfering patterns 14 are formed and the surface of the silicon substrate 10 is exposed are selectively etched. Further, according to the RIE method, the etching proceeds in the thickness direction while maintaining the planar shapes of the chamfering patterns 14, and the through holes 18 are formed in the same pattern as the planar shapes of the chamfering patterns 14.

After the through holes 18 are formed in the silicon substrate 10, the resist 12 is removed. Then, the silicon chips 20 are formed as the individual pieces from the silicon substrate 10.
As the method of forming the silicon chips 20 as the individual pieces from the silicon substrate 10, there are a method of dividing the silicon substrate into individual pieces by moving the dicing blade (rotary blade) along the dividing lines A, and a method of dividing the silicon substrate into individual pieces by cleaving the silicon substrate along the dividing lines A.

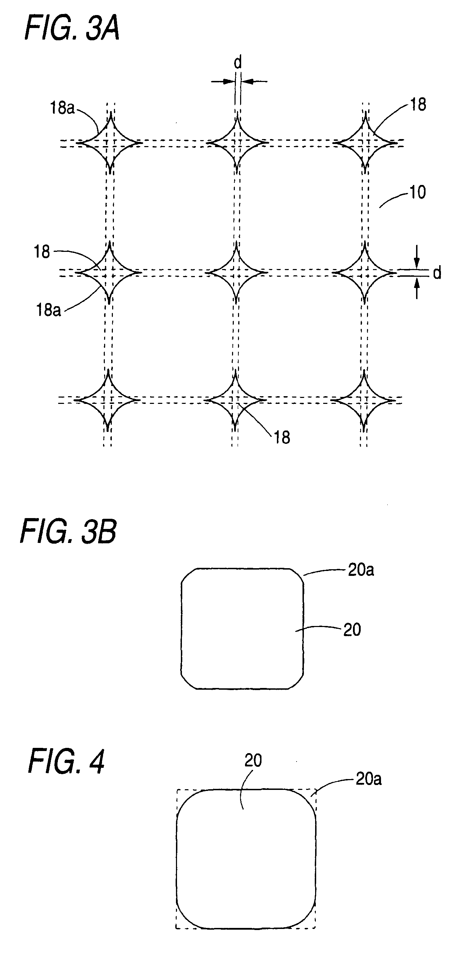

FIG.3A shows a state where the silicon substrate is divided by moving the dicing blade along the dividing line A. In this state, the dicing blade is moved to connect centers of the through holes 18 formed in the modified quadrangular shape while a reference symbol "d" denoting a passing width of the dicing blade.
FIG.3B shows one silicon chip 20 that is divided into individual pieces. A corner portion 20a of the silicon chip 20 is chamfered like a circular arc. When the silicon substrate 10 is divided by using the dicing blade, the through holes 18 must be formed such that a maximum width of the through hole 18 is wider than twice of the passing width d of the dicing blade in order to chamfer the corner portion 20a of the silicon chip 20. (Here, the maximum width is defined by the diagonal line between the two vertexes of the modified quadrangular shape of the chamfering pattern 14.) In other words, when dicing blade is moved in the lengthwise and crosswise directions, a shape and a size of the through hole 18 should be set such that an edge portion 18a of the through hole 18 remains on the silicon chip 20 side, and the dicing blade having the predetermined passing width d is employed.

As shown in FIG.3A, according to the method of dividing the silicon substrate 10 by moving the dicing blade on the silicon substrate 10 in which the through holes 18 are formed, the silicon substrate 10 is prevented from chipping of the corner portion of the silicon chip 20 or opening of the crack in the corner portion, which otherwise may be occurred due to a stress concentration on the corner portion of the silicon chip 20 during the dicing. Further, because the corner portion 20a of the silicon chip 20 is shaped into the chamfered form, strength of the silicon chip 20 is improved. Therefore, the corner portion of the silicon chip 20 is prevented from chipping or being damaged in handing the silicon chip 20.

FIG.4 shows the silicon chip 20 obtained by the method that cleaves the silicon substrate 10 along the dividing line A. A cleavage of the silicon substrate 10 is started from the edge portion (vertex) of the through hole 18 formed in the silicon substrate 10 as a start point. In this embodiment, the chamfering line 14a is tangent to the dividing line A at vicinity of the corner portion of the through hole 18, and the chamfering lines 14a which oppose to each other via the dividing line A intersect with each other while forming a sharp acute angle. Therefore, a corner portion of the through hole 18 surely acts as a start point of the cleavage.
Because the through holes 18 are formed on each of the corner portions of the silicon chip 20, when cleaving the silicon substrate 10, neither the chipping nor the crack is caused in the corner portion of the silicon chip 20.

Here, when an orientation of a crystal growth face of the silicon substrate 10 is a (100) face, it is effective that the direction of the dividing line A being set on the silicon substrate 10 should be set in parallel with the direction of the crystal face of the silicon substrate 10. When the dividing line A (dividing position) is set in parallel with the crystal growth face of the silicon substrate 10, the cleaving direction coincides with the direction of the dividing line A in cleaving the silicon substrate 10. Thus, the silicon substrate 10 can be cleaved easily while not applying an unnecessary stress to the silicon chip 20.

As the method of separating the silicon substrate 10 into individual pieces, such a method may be employed that the cutting grooves are formed to align with positions of the dividing lines A and then the silicon substrate is broken into individual pieces in the positions of the cutting grooves. Also, a method of making a dividing scratch by the scraper to align with the dividing lines A of the silicon substrate 10 and then dividing the silicon substrate into individual pieces may be employed. According to any method of them, when the through holes 18 for chamfering are formed previously in the silicon substrate 10, the silicon substrate 10 can be divide into individual pieces while not causing any breaks or chippings in the silicon chip 20, like the above.

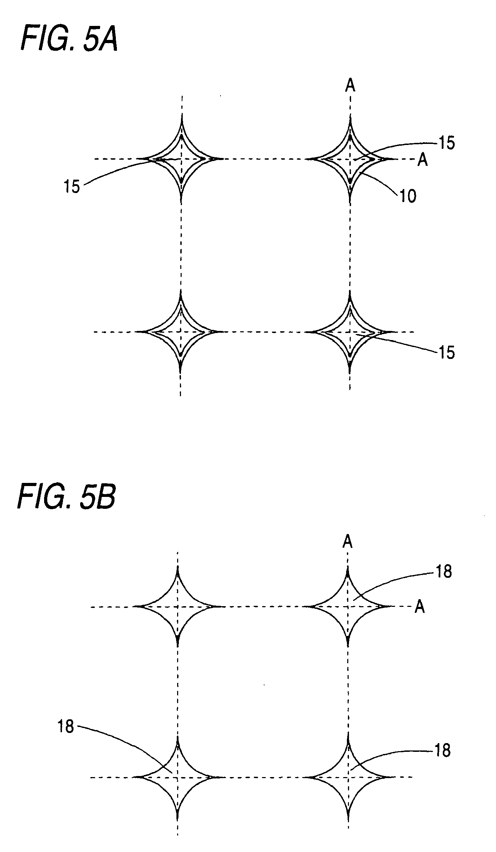

As described above, the chip forming method of this embodiment is characterized in that the through holes 18 for chamfering are formed to align with the intersection points of the dividing lines A when the silicon chips 20 are formed by dividing the silicon substrate 10 into individual pieces, and then the silicon substrate 10 is cut or divided into individual pieces on a basis of the positions of the through holes 18.
As the forming method of the through hole 18, in the above embodiment, the chamfering pattern 14 which has the same shape of a sectional shape of the through hole 18 is formed on the silicon substrate 10. However, instead of this method, as shown in FIG.5A, a chamfering patterns 15 of which shape corresponds to a contour (outline) of the through hole 18 and which has predetermined width can be formed on the silicon substrate 10.

FIG.5A shows a state that, after covering the surface of the silicon substrate 10 with the resist 12, the chamfering patterns 15 is formed at a position corresponding to the through hole 18 which is to be formed on the silicon substrate 10 so that a shape thereof corresponds to the contour of the through hole 18. In this state, a part of the surface of the silicon substrate 10 which corresponds to the contour of the through hole 18 is exposed from the resist 12.
The chamfering patterns 15 of this embodiment are formed by exposing and developing the resist 12 such that the part of the surface of the silicon substrate 10 which corresponds to the contour of the through hole 18 is exposed as the modified quadrangular shape whose four sides are curved like a circular arc respectively.

In this manner, when the chamfering patterns 15 from which the part of the surface of the silicon substrate 10 is exposed are formed to correspond to the contour of the through hole 18, respectively, and then the silicon substrate 10 is etched by the RIE method, for example, the silicon substrate 10 is etched in the thickness direction to align with the exposed portions of the chamfering patterns 15. Therefore, portions surrounded by the chamfering patterns 15 are removed out. As shown in FIG.5B, the through holes 18 whose planar shape is the modified quadrangular shape respectively are formed.
According to this method, the through holes 18 are formed by etching the part of the silicon substrate which corresponds to the contour of the through holes 18 only in a predetermined width, respectively. Therefore, an amount of the silicon substrate removed by the etching is reduced rather than the case where the silicon substrate 10 is etched over the whole planar area of the through hole 18, and also an etching time can be shortened.

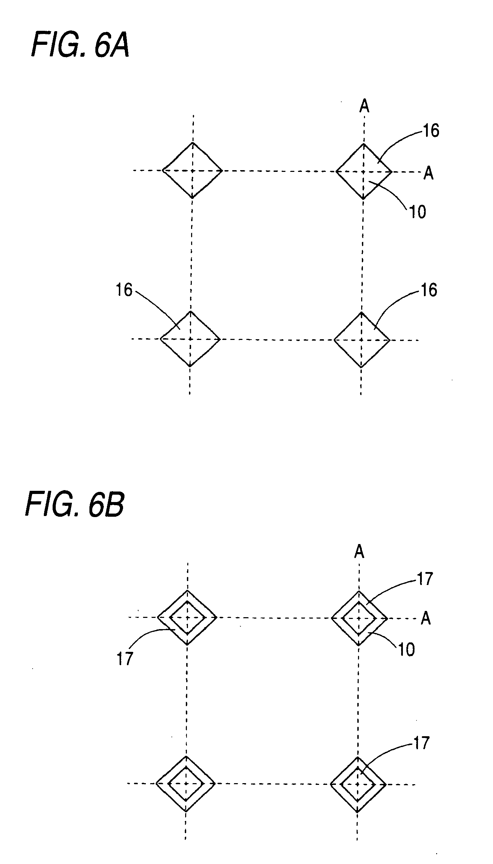

In the above embodiments, in the chamfering patterns 14, 15 formed on the surface of the silicon substrate 10, the corner portion 20a of the silicon chip 20 is chamfered like a circular arc shape or a curved shape. FIGs.6A and 6B show an example in which the corner portions 20a of the silicon chip 20 are chamfered linearly.
FIG.6A is an example that chamfering patterns 16 are shaped into a rectangle whose vertex is positioned on the dividing line A. The silicon substrate 10 is exposed from the resist only in rectangle area in which the chamfering pattern 16 is formed. FIG.6B is an example that chamfering patterns 17 in which a part of the surface of the silicon substrate 10 which corresponds to the contour of a rectangle whose vertex is positioned on the dividing line A is exposed from the resist in a predetermined width.

When either of the chamfering patterns 16, 17 shown in FIGS.6A and 6B is formed, the rectangular through holes are formed in the silicon substrate 10 by etching the silicon substrate 10, and then individual silicon chips 20 can be obtained by applying the separating method, for example, the silicon substrate 10 is cut by using the dicing blade to align with the center positions of these through holes, the silicon substrate 10 is cleaved in positions of the dividing lines A, or the like.
FIG.7 shows the silicon chip 20 obtained from the silicon substrate 10 in which the rectangular through holes are formed by forming the chamfering patterns 16, 17 shown in FIG.6. The corner portion 20a of the silicon chip 20 is chamfered linearly as a 45-degree cut.

In this manner, when individual silicon chips 20 are formed from the silicon substrate 10 by forming the through holes in which the corner portion 20a of the silicon chip 20 is chamfered linearly respectively, the corner portion 20a of the silicon chip 20 has an obtuse angle. Therefore, like the above embodiment, in dividing the silicon substrate 10, the corner portion of the silicon chip 20 is prevented from chipping or opening of the cracks in the corner portion. Also, because the corner portions 20a of the resultant silicon chip 20 are chamfered, the strength can be improved, and thus the silicon chip 20 can be prevented from being damaged in handling the silicon chip 20.

Also, like this embodiment, even when the through holes formed as the rectangle for chamfering are aligned lengthwise and crosswise, the edge portions of the through holes opened as the rectangle are positioned on the dividing lines A. Therefore, individual silicon chips 20 can be obtained easily by cleaving the silicon substrate 10 from the edge portions of the through holes as a start point.

As the shape of the chamfering through hole 18 formed in the silicon substrate 10, in addition to the above modified quadrangular shape or the rectangular shape, either a rhombus that has a different intersection angle between the dividing line A and each side respectively or a common quadrangle that surrounds the dividing line A can be employed.

Although in the embodiments, the methods of forming individual silicon chips 20 from the silicon substrate 10 is explained as an example. However, as the silicon substrate 10, a mere silicon substrate may be employed, a semiconductor wafer on which semiconductor circuits are formed may be employed, or a silicon substrate in which connection portions such as through holes formed in an interposer used in a semiconductor device, or the like are formed may be employed.

In the semiconductor wafer, a dicing space whose width is about 50 to 100 µm is ensured in the middle of adjacent semiconductor chips. Therefore, the through holes for chamfering are formed within a range not to have an influence on the circuits that are formed on the semiconductor chip, and individual semiconductor chips can be obtained. Since the corner portions of the semiconductor chip are chamfered, the strength can be improved, and thus the breaks caused in handling can be prevented.
Recently, for the purpose of downsizing the semiconductor device, a thin semiconductor chip is provided by grinding the back surface of the wafer at the stage of the semiconductor wafer. The substrate dividing method of the present invention can be utilized particularly effectively in preventing the damage of the semiconductor chip when the semiconductor chips are formed by dividing the thin semiconductor wafer into individual pieces.

Also, the present invention can be applied to a compound semiconductor wafer made of GaAs, or the like as well as the substrate made of silicon such as the semiconductor wafer.
Also, when a large-size substrate made of inorganic material such as a glass plate, a ceramic plate, or the like is divided into individual pieces, the present invention can be applied completely similarly.
In the present embodiment, in order to form the through holes for chamfering in the silicon substrate, the through holes are formed in the silicon substrate by coating the surface of the substrate with the resist, forming the chamfering patterns, and applying the etching by the RIE method. But the method of forming the through holes is not limited to the above method, and any method can be chosen appropriately in response to the worked object.
While the invention has been described in connection with the exemplary embodiments, it will be obvious to those skilled in the art that various changes and modifications may be made therein without departing from the present invention, and it is aimed, therefore, to cover in the appended claim all such changes and modifications as fall within the true spirit and scope of the present invention.

## Claims

1. A substrate dividing method of dividing a substrate (10) into individual pieces, comprising steps of:
setting dividing lines (A) onto the substrate (10) in lengthwise and crosswise directions at a predetermined interval;
forming through holes (18) on the substrate at respective intersection points of the dividing lines so as to chamfer corner portions of the individual pieces of the substrate and
dividing the substrate (10), on which the through holes (8) are formed, into individual pieces along the dividing lines.

2. The substrate dividing method according to claim 1, wherein the step of forming the through holes (18) comprises:
coating a surface of the substrate with a resist;
forming chamfering patterns on the resist so as to expose a surface of the substrate at the respective intersection points of the dividing lines and
etching the substrate (10) by using the resist on which the chamfering patterns are formed as a mask so as to form the through holes.

3. The substrate dividing method according to claim 2, wherein
each of the chamfering patterns is formed as a pattern of which shape corresponds to a contour of the through hole with predetermined width.

4. The substrate dividing method according to any one of claims 1 to 3, wherein
the substrate is divided into individual pieces by cutting the substrate by a dicing blade along the dividing lines.

5. The substrate dividing method according to any one of claims 1 to 3, wherein,
the substrate is divided into individual pieces by cleaving the substrate along the dividing lines.

6. The substrate dividing method according to claim 5, wherein
the dividing lines are set so as to be in parallel with a direction of a crystal growth face of the substrate.

7. The substrate dividing method according to any one of claims 1 to 6, wherein,
each of the through holes is shaped into a quadrangle which surrounds the intersection point of the dividing lines and four vertexes of which are positioned on the dividing line, respectively.

8. The substrate dividing method according to any of the precedent claims, wherein
each of the through holes is shaped into a modified quadrangular shape whose respective sides are convexly curved toward the intersection point of the dividing lines, respectively.

9. The substrate dividing method according to any one of claims 1 to 8, wherein the substrate is a silicon substrate.

10. The individual pieces of a divided substrate obtainable by any of the precedent claims.
